# EUROPÄISCHE PATENTANMELDUNG

(11) **EP 4 170 063 A1**
(43) Veröffentlichungstag der Anmeldung: **26.04.2023**
(21) Anmeldenummer: 22162190.7
(22) Anmeldetag: 15.03.2022
(51) Int. Cl.: C23C 16/455, H01M 4/88, C25B 1/04, C25B 11/052, C25B 11/091, C25B 11/059

(54) **METHODE ZUR HERSTELLUNG AKTIVER UND STABILER TITANBASIERTER MISCHOXIDKATALYSATOREN MIT OPTIMIERTER EDELMETALLVERTEILUNG DURCH OBERFLÄCHENKONFORME ATOMLAGENABSCHEIDUNG**

(30) Priorität: 19.10.2021 DE 102021127140; 16.12.2021 DE 102021133530
(71) Anmelder: Technische Universität Berlin, 10623 Berlin (DE); Humboldt-Universität zu Berlin, 10099 Berlin (DE)
(72) Erfinder: Frisch, Marvin, 10707 Berlin (DE); Krähnert, Ralph, 13469 Berlin (DE); Raza, Muhammad Hamid, 10785 Berlin (DE); Pinna, Nicola, 14165 Berlin (DE)
(74) Vertreter: Hertin und Partner Rechts- und Patentanwälte PartG mbB

(57) **Zusammenfassung**

In einem ersten Aspekt betrifft die Erfindung ein Verfahren zur Herstellung nanostrukturierter Elektrodenbeschichtungen. Hierbei wird zunächst ein Trägermaterial bereitgestellt, wobei das Trägermaterial ein Edelmetall-Titan-Mischoxid umfasst. Daraufhin wird das Trägermaterial mit einer katalytisch aktiven Edelmetallspezies mittels Atomlagenabscheidung (ALD) beschichtet, sodass das Trägermaterial durch die katalytisch aktive Edelmetallspezies oberflächenkonform modifiziert wird.

Zudem betrifft die Erfindung eine Verwendung des mittels der Atomlagenabscheidung oberflächenmodifizierten Trägermaterials als Katalysator und/oder Katalysatorträger, wobei vielseitige Einsatzmöglichkeiten vorliegen.

## Beschreibung

In einem ersten Aspekt betrifft die Erfindung ein Verfahren zur Herstellung nanostrukturierter Elektrodenbeschichtungen. Hierbei wird zunächst ein Trägermaterial bereitgestellt, wobei das Trägermaterial ein Edelmetall-Titan-Mischoxid umfasst. Daraufhin wird das Trägermaterial mit einer katalytisch aktiven Edelmetallspezies mittels Atomlagenabscheidung (ALD) beschichtet, sodass das Trägermaterial durch die katalytisch aktive Edelmetallspezies oberflächenkonform modifiziert wird.

Zudem betrifft die Erfindung eine Verwendung des mittels der Atomlagenabscheidung oberflächenmodifizierten Trägermaterials als Katalysator und/oder Katalysatorträger, wobei vielseitige Einsatzmöglichkeiten vorliegen.

### Hintergrund und Stand der Technik

Die elektrochemische Herstellung von Wasserstoff (H₂) durch die Elektrolyse von Wasser (H₂O) stellt einen wesentlichen Grundbaustein für den Übergang zur nachhaltigen Erzeugung sowie Speicherung und Umsetzung von Energie dar. Die Elektrolyse von Wasser mittels Protonenaustauschmembran-Elektrolyseuren (PEM, engl. proton exchange membrane) wird hierbei als eine der vielversprechendsten Schlüsseltechnologien in der wachsenden Wasserstoffwirtschaft betrachtet. Eine aktuelle Machbarkeitsstudie von Minke et al. (2021) zeigt, dass eine ökonomische Herstellung großer Mengen an molekularem Wasserstoff durch PEM-Elektrolyse in erster Linie durch die hohen Kosten der verwendeten Edelmetall-basierten Katalysatormaterialien limitiert wird. Besonders die Verwendung des äußerst seltenen und kostenintensiven, jedoch gleichzeitig überaus aktiven und stabilen, Iridium-Metalls (Ir) auf der Anodenseite stellt eine Herausforderung dar. Die oxidativen und korrosiven Bedingungen in einem PEM-Elektrolyseur erfordern in diesem Kontext die Entwicklung hochaktiver und korrosionsbeständiger Materialien für den Einsatz als Elektrokatalysatoren für die an der Anode ablaufende Sauerstoffevolutionsreaktion (OER, oxygen evolution reaction, auch Sauerstoffbildungsreaktion genannt).

Vorausgegangene Arbeiten haben gezeigt, dass sich besonders Iridiumoxid- und Iridium-Titanoxidmaterialien als aktiv für die Wasserelektrolyse in saurer Umgebung (pH < 7) erweisen. Für eine ausreichend hohe Stabilität und Schutz vor unerwünschter Degradation der Katalysatoren ist jedoch bisher ein relativ hoher Edelmetallgehalt erforderlich. Kommerziell erhältliche OER-Katalysatoren basieren derzeit auf Iridium-Titanoxidpulvern mit einem Gehalt von etwa 70 - 75 Gew.-% Ir in TiO₂ (z. B. Elyst Ir 75 0480, Umicore). Der hohe Gehalt an Iridium resultiert aus der Tatsache, dass Iridium sowohl für die Aktivität als auch Stabilität sowie zugleich für eine gute elektrische Leitfähigkeit des Katalysators benötigt wird.

In vorherigen Arbeiten wurde der Einfluss des Ir-Gehaltes in Iridium-Titanmischoxiden sowohl auf die elektrische Leitfähigkeit als auch die katalytische OER-Aktivität aufgeklärt. Dazu wurden von Bernsmeier et al. (2018) verschiedene Zusammensetzungen von gering kristallinen Iridium-Titanoxid-Modellsystemen (Ir_{y}Ti_{1-y}O₂) in Form mesoporöser Schichten mittels Tauchbeschichtung synthetisiert und hinsichtlich ihrer physikochemischen und elektrokatalytischen Eigenschaften (OER-Aktivität in saurer Umgebung) untersucht. Als eines der zentralen Ergebnisse der Studie wurde ein Ir-Gehalt von mindestens 15 mol-% bzw. 30 Gew.-% im Mischoxid identifiziert, welcher essentiell für eine ausreichende Leitfähigkeit und OER-Aktivität ist. Darüber hinaus wurde in mehreren Arbeiten gezeigt, dass die Einführung einer (meso)porösen Strukturierung die katalytische Aktivität der geträgerten Ir-haltigen Elektrodenbeschichtungen signifikant verbessert verglichen mit nicht-porösen Materialien ähnlicher Zusammensetzung bzw. Phase (siehe hierzu beispielsweise Ortel et al. (2011)).

Für eine Einsparung an Edelmetall bei gleichbleibend hoher katalytischer Aktivität ist es erstrebenswert, nanostrukturierte Elektrodenbeschichtungen mit einer optimierten Verteilung an Edelmetallspezies zu entwickeln. Für eine hohe katalytische Aktivität sollen sich möglichst viele aktive Spezies exponiert an der Katalysatoroberfläche befinden. Allerdings ist es mit den derzeitigen Mitteln des Standes der Technik nicht bekannt, effiziente und stabile Katalysatoren bereitzustellen, die eine geeignete Verteilung der Edelmetallpartikel aufweisen. Weiterhin ist es im Stand der Technik problematisch, Parameter der Katalysatoren wie Schichtdicken und/oder die Kristallinität zu optimieren.

### Aufgabe der Erfindung

Aufgabe der Erfindung war es, die Nachteile des Standes der Technik zu beseitigen und ein Verfahren zur Herstellung von geeigneten Oberflächen, insbesondere von geeigneten Katalysatoren und/oder Elektroden, bereitzustellen, die eine geeignete Verteilung von Edelmetallen aufweist und damit eine effiziente elektrische Leitfähigkeit ermöglicht. Weiterhin sollte das Verfahren besonders prozesseffizient und verfahrensökonomisch ausgestaltet sein.

### Zusammenfassung der Erfindung

Die erfindungsgemäße Aufgabe wird gelöst durch die Merkmale der unabhängigen Ansprüche. Vorteilhafte Ausgestaltungen der Erfindung sind in den abhängigen Ansprüchen beschrieben.

In einem ersten Aspekt betrifft die Erfindung ein Verfahren zur Herstellung nanostrukturierter Elektrodenbeschichtungen umfassend folgende Schritte:
a) Bereitstellung eines Trägermaterials, wobei das Trägermaterial ein Edelmetall-Titan-Mischoxid umfasst,
b) Beschichtung des Trägermaterials mit einer katalytisch aktiven Edelmetallspezies mittels Atomlagenabscheidung (ALD),
sodass das Trägermaterial durch die katalytisch aktive Edelmetallspezies oberflächenkonform modifiziert wird.

Das bevorzugte Verfahren hat sich in vielerlei Hinsicht als besonders vorteilhaft erwiesen.

Es war überraschenderweise besonders vorteilhaft, dass mittels des bevorzugten Verfahrens hocheffiziente und stabile Katalysatoren mit optimierter Edelmetallverteilung hergestellt werden konnten. Beispielsweise konnte ein ausreichend elektrisch leitfähiges Iridium-Titanoxid-basiertes Trägermaterial mit katalytisch aktiven Iridiumoxid-Spezies (IrOₓ) als katalytisch aktive Metallspezies mithilfe von oberflächenkonformer Atomlagenabscheidung (ALD) modifiziert werden.

Insbesondere der Einsatz der Methode der Atomlagenabscheidung hat sich als besonders vorteilhaft erwiesen. Es war völlig unerwartet, dass die Parameter der Oberflächenmodifikation *via* ALD die Abscheidung einer äußerst homogenen, oberflächenkonformen Oberflächenschicht, welche lediglich geringe Dicken im Bereich weniger Nanometer (nm) aufweist, ermöglichte. Darüber hinaus wurde eine genaue Kontrolle über die Kristallinität, Schichtdicke sowie Phasenzusammensetzung dieser abgeschiedenen Oberflächenschicht durch eine Anpassung der relevanten ALD-Parameter erreicht.

Weiterhin war es von besonders großem Vorteil, dass durch das bevorzugte Verfahren die Eigenschaften des Materialvolumens (relevant für die elektrische Leitfähigkeit sowie für eine hohe spezifische Materialoberfläche durch definierte Porosität) und der Grenzfläche zur Umgebung (OER-Aktivität sowie -Stabilität) getrennt voneinander optimiert werden konnten.

Beispielsweise führt dies einerseits zu einer Verringerung der im Volumen benötigten Ir-Menge, andererseits zu einer Anreicherung des aktiven Ir an der Grenzfläche zwischen Material und Umgebung (d. h. Elektrolyt). Die Optimierung der genannten Parameter ermöglicht somit die Entwicklung von höchst effizienten Elektrokatalysatoren mit gesteigerter Aktivität pro Gesamtmasse an Ir-Edelmetall (Massenaktivität), z. B. in der elektrochemischen Wasserspaltung zur H₂-Erzeugung. Eine gesteigerte Aktivität wird hierbei im Allgemeinen mit einer höheren Produktion an gasförmigem Reaktionsprodukt (H₂ an der Kathode, O₂ an der Anode im Falle der Wasserelektrolyse) bei einem bestimmten angelegten Potential definiert. Die OER-Teilreaktion an der Anodenseite wurde gemäß dem Stand der Technik als limitierend ermittelt, weil komplexe Reaktionsschritte (insbesondere eine hohe Anzahl an elektrischen Ladungsträgern) und - zwischenprodukte (Intermediate) involviert sind. Im Rahmen elektrochemischer Testungen zeigt sich eine hohe katalytische OER-Aktivität eines Katalysatorsystems anhand hoher geometrisch normierter Stromdichten bei einem moderaten Potential > 1,23 V (reversible Zellspannung der Wasserspaltung bei T = 25 °C).

Die Methode der Atomlagenabscheidung (atomic layer deposition, ALD) eignet sich in ganz besonderem Maße für die definierte Abscheidung geringster Mengen an Metall(oxid)spezies. Charakteristisch für den Prozess der ALD ist die oberflächenkonforme Beschichtung, da idealerweise ein selbstlimitierender Reaktionsmechanismus mit der Oberfläche zugrunde liegt.

Das erfindungsgemäße Verfahren beruht auf einer Methode zur Herstellung von Elektrodenmaterialien bzw. Elektrodenbeschichtungen mit optimierter Verteilung von katalytisch aktiver Edelmetallspezies, beispielsweise auf Basis von elektrisch leitfähigen Edelmetall-Titanoxid-, vorzugsweise Ir_{y}Ti_{1-y}O₂-, Trägermaterialien, deren gesamte Materialoberfläche mittels Atomlagenabscheidung mit hoch aktiven Edelmetall-, vorzugsweise IrOₓ-, Spezies modifiziert wird.

Vorteilhafterweise kann durch das erfindungsgemäße Verfahren die Anzahl an exponierten katalytisch aktiven, edelmetallbasierten Zentren vergrößert werden, um die Effizienz und die Wirtschaftlichkeit der Katalysatoren zu verbessern. Dies kann durch eine gesteigerte Edelmetallmassenspezifische Aktivität der Katalysatoren bspw. in der elektrochemischen OER realisiert werden. Entscheidend ist hierfür eine Variation der eingesetzten ALD-Parameter, wie beispielweise die Präkursorverbindungen, Anzahl, sowie Dauer der ALD Zyklen und/oder die Temperatur, um eine oberflächenkonforme Bedeckung bzw. Beschichtung des Trägers zu garantieren und die intrinsische katalytische Aktivität der oberflächennahen Edelmetallzentren vorteilhaft zu beeinflussen. Durch die abgeschiedene Oberflächenschicht mit einstellbarer Zusammensetzung, Kristallinität, Schichtdicke sowie Morphologie kann darüber hinaus eine verbesserte katalytische Stabilität der Elektrode erreicht werden. In diesem Kontext können eine Degradation und eine damit einhergehende Verringerung der katalytischen OER-Aktivität mit der Zeit im Vergleich zu einer Elektrode basierend auf unmodifiziertem Trägermaterial deutlich reduziert werden. Demzufolge wird eine erhebliche Verbesserung gegenüber dem Stand der Technik erzielt durch das bevorzugte Verfahren.

In klarer Abgrenzung zu bereits bekannten Herstellungsmethoden ist bevorzugt für Ir-basierte Katalysatorsysteme im erfindungsgemäßen Kontext vorzugsweise ein Ir_{y}Ti_{1-y}O₂-Mischoxid als leitfähiges Trägermaterial für die nachfolgende Oberflächenmodifikation mit dünnen Atomlagen in der Größenordnung weniger nm umfassend katalytisch höchst aktivem sowie stabilem IrOₓ beschrieben.

Mithin konnte vorteilhafterweise durch den Einsatz der ALD eine verbesserte Kontrollierbarkeit der Beschichtung der katalytisch aktiven Edelmetallspezies auf das Trägermaterial erlangt werden. Der Einsatz eines Edelmetall-Titan-Mischoxides für das Trägermaterial war dahingehend vorteilhaft, dass hierdurch eine besonders zuverlässige Anbindung mit der katalytisch aktiven Edelmetallspezies ermöglicht wurde.

Im Sinne der Erfindung bezeichnet eine nanostrukturierte Elektrodenbeschichtung eine Beschichtung auf einer Elektrode, die Nanostrukturen aufweist, wobei mit einer Nanostruktur eine Struktur im Bereich von Nanoskalen gemeint ist. Beispielsweise kann mit einer Nanostruktur eine Porosität gemeint sein, die im Nanometerbereich liegt. So können beispielsweise Poren der Elektrodenbeschichtung vorliegen, die mikroporös (< 2 nm) oder mesoporös (2 - 50 nm) sind. Ebenfalls ist eine Makroporosität (> 50 nm) möglich. Eine Nanostruktur kann ebenfalls eine oder mehrere Schichtdicken im Nanometerbereich meinen.

Bevorzugt wird die nanostrukturierte Elektrodenbeschichtung als Katalysator eingesetzt, beispielsweise im Rahmen einer Elektrolyse, bevorzugt einer Elektrokatalyse.

Ein Trägermaterial bezeichnet vorzugsweise ein Material, auf der Partikel und/oder Atomlagen eines Edelmetalls und/oder Edelmetalloxids aufgebracht werden, wobei die aufgebrachten Partikel und/oder Atomlagen den Katalysator für eine chemische Reaktion bereitstellen. In gewisser Weise kann damit bevorzugt das Trägermaterial als Träger der aktiven Edelmetall-Oberflächenspezies aufgefasst werden. Eine hohe spezifische Oberfläche (sogenannte BET-Oberfläche, typischerweise massennormiert angegeben) eines Trägermaterials wird im Allgemeinen angestrebt, um eine gesteigerte Anzahl an zugänglichen, aktiven Katalysatorspezies als auch eine hohe elektrochemisch aktive Oberfläche (sogenannte ECSA, electrochemical surface area oder auch electrochemically active surface area) zu realisieren. Eine hohe Anzahl zugänglicher Katalysatorzentren steigert die massenbezogene Aktivität des gesamten Katalysatorsystems umfassend Trägermaterial und Oberflächenbeschichtung.

Ein Edelmetall-Titan-Mischoxid bezeichnet bevorzugt einen Stoff mit einem Kristallgitter umfassend Sauerstoff-Anionen, Titan-Kationen sowie Kationen eines Edelmetalls. Damit ist bevorzugt ein Edelmetall-Titian-Mischoxid ein Komplex-Oxid, wobei bevorzugt verschiedene Anteile eines Edelmetalls, Titan und/oder Sauerstoff vorliegen können.

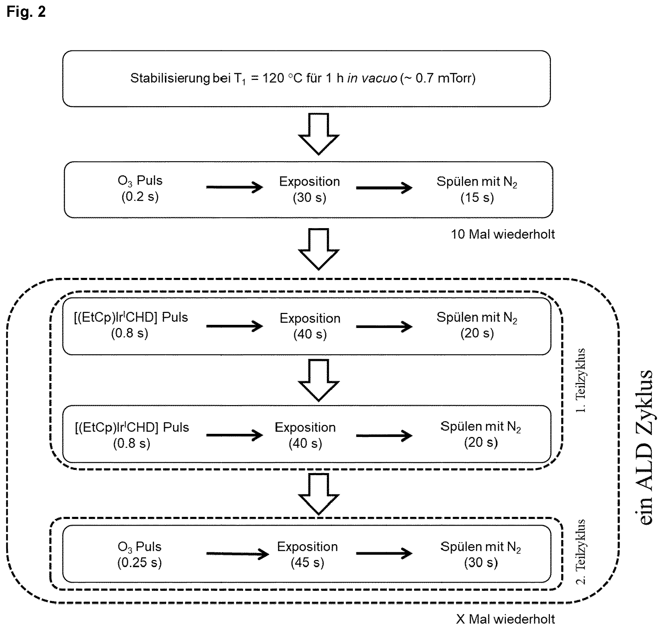

Eine Atomlagenabscheidung (abgekürzt mit ALD) bezeichnet einen Prozess der Dünnschichtabscheidungen. Bei der Atomlagenabscheidung werden nacheinander verschiedene chemische Reaktanten, sogenannte Präkursoren, in einem Reaktor zur Reaktion gebracht. Die einzelnen Reaktanten werden bevorzugt einzeln in die Reaktorkammer eingeleitet und ihre Reaktionen mit dem Trägermaterial bzw. der exponierten Oberfläche(nspezies) ist selbstlimitierend (im Kontext der Erfindung bezeichnet vorzugsweise eine selbstlimitierende Reaktion eine Reaktion an einer Oberfläche, bei welcher der jeweilige Reaktant im Wesentlichen vollständig verbraucht wird und sich vorzugsweise gasförmige Nebenprodukte bilden). Hierdurch entsteht idealerweise bei jedem Prozessschritt nur eine sehr dünne Schicht umfassend eine einzelne Atomlage. Im darauffolgenden Schritt reagiert ein weiterer Reaktant mit dieser Atomlage und bildet die gewünschte chemische Verbindung. Die ALD im Kontext der Erfindung wird auch in der Beschreibung der Fig. 2 diskutiert. Im Stand der Technik wird auf die allgemeine Tendenz verschiedener Edelmetalle bei dem Prozess der ALD hingewiesen, bevorzugt partikelartige, nicht-konforme Oberflächenstrukturen auszubilden. Die Wahl der Präkursoren kann in Kombination mit den gewählten ALD-Parametern (insbesondere der Temperatur der Reaktionskammer) die Kristallinität, die Zusammensetzung, den mittleren Oxidationszustand und auch die Morphologie der abgeschiedenen oberflächennahen Strukturen beeinflussen. Bislang konnte keine Methode für die Abscheidung homogener, konformer und gleichzeitig sehr dünner (wenige nm Schichtdicke) als auch niedrig-kristalliner Iridiumoxid-Lagen auf einem Trägermaterial identifiziert werden. Niedrig-kristalline, oxidische Iridiumspezies (IrOₓ) weisen laut Stand der Wissenschaft vorteilhafte katalytische Eigenschaften (hohe OER-Aktivität, ausreichende - Stabilität in saurer Umgebung) auf, welche auf die elektronische Struktur und die Tendenz zur Ausbildung von formalen Ir^{V+} - Spezies (kationische Iridiumspezies mit einer formalen Oxidationsstufe von +5, welche gebunden an elektronen-arme, anionische O^{I-} - Sauerstoffspezies mit einer Oxidationsstufe von -1 vorliegen) während der OER-Elektrokatalyse zurückzuführen sind. Diese lokale Verarmung an Elektronendichte verringert die Energiebarriere für die Aktivierung eines h₂O-Moleküls in direkter Nachbarschaft zur Oberfläche.

Eine katalytisch aktive Edelmetallspezies bezeichnet bevorzugt ein Edelmetall und/oder eine Verbindung umfassend ein Edelmetall, die als Katalysator eingesetzt werden kann. Bevorzugt handelt es sich bei der katalytisch aktiven Edelmetallspezies um eine Iridiumoxid-Spezies (IrOₓ). Weiterhin ist es bevorzugt, dass die Iridiumoxid-Spezies niedrig-kristallin ist.

Im Sinne der Erfindung bezieht sich der Ausdruck "niedrig-kristallin" bevorzugt auf einen geringen Kristallinitätsgrad eines Materials, welcher durch eine nicht streng periodische Anordnung von Atomen in einem Gitter eines Festkörpers bzw. eine fehlende Fernordnung definiert ist. Bei niedrig-kristallinen Materialien liegt eine gewisse Nahordnung der einzelnen Atome vor, welche bei vollständig amorphen (= nichtkristallinen) Materialien in eine vollkommen regellose Struktur übergeht. Im Sinne der Erfindung schließt der Ausdruck "niedrig-kristallin" bevorzugt solche Materialien bzw. Festkörper ein, welche eine begrenzte räumliche Nahordnung, jedoch keine Fernordnung (d. h. keine Translationssymmetrie im Atomgitter) aufweisen. Röntgenspektroskopische Charakterisierungsmethoden (Röntgenanalyse) zeigen für niedrig-kristalline Materialien schwach ausgeprägte Beugungsmuster bestehend aus (kreis-)symmetrischen, ringförmigen Signalen, welche im Vergleich zu Materialien mit einem höheren Kristallinitätsgrad weniger scharf ausgeprägt sind.

In einer weiteren bevorzugten Ausführungsform ist das Verfahren dadurch gekennzeichnet, dass das Trägermaterial ein Edelmetall aufweist, wobei das Edelmetall in einem titanbasierten Metalloxid (-Gitter) vorliegt, sodass eine elektrische (Volumen-)Leitfähigkeit des Trägermaterials variiert werden kann.

Eine Kombination von Edelmetall und titanbasierten Metalloxiden hat sich überraschenderweise als besonders vorteilhaft herausgestellt. Ir_{y}Ti_{1-y}O₂-Mischoxide können auf Grundlage zuvor etablierter Herstellungsmethoden in Form von mesoporös templatierten Schichten mittels Tauchbeschichtung auf geeigneten Substraten abgeschieden und nach einer thermischen Behandlung in niedrig-kristalline Oxide überführt werden. Hierfür können beispielsweise geeignete Metallpräkursoren sowie ein porenformendes Templat mit amphiphilen Eigenschaften in einem bestimmten Lösungsmittel(gemisch) verwendet werden.

Vorteilhafterweise kann anhand des Verhältnisses der Metallpräkursoren für Ir bzw. Ti (Titan) die Stöchiometrie der entstehenden Mischoxide präzise eingestellt werden. Entscheidend ist, dass der Gehalt an Ir im Mischoxid einen signifikanten Einfluss auf die elektrischen und katalytischen Eigenschaften der porösen Materialien aufweist. Als Minimum einer ausreichend hohen elektrischen Leitfähigkeit wurde ein Gehalt von ca. 15 mol-% bzw. ca. 30 Gew.-% Ir in Ir_{y}Ti_{1-y}O₂ identifiziert. Für geringe relative Ir-Anteile wurde eine drastisch verminderte katalytische Aktivität in der elektrochemischen OER in saurer Umgebung beobachtet. Für ausreichend hohe Ir-Anteile lassen sich auf diese Weise katalytisch sehr aktive OER-Katalysatoren erzeugen (siehe auch Bernicke et al. (2019) und Bernsmeier et al. (2018)).

Im Rahmen der vorliegenden Erfindung zeigte sich jedoch, dass die katalytische Stabilität für die Mischoxide mit geringen Ir-Anteilen unter oxidativen und korrosiven Bedingungen unzureichend ist. In diesem Kontext wurde ein Auflösungsverhalten der Katalysatorbeschichtungen bei Stabilitätsmessungen über mehrere Tage in saurem Elektrolyten beobachtet. Ein weiterer wichtiger Faktor bei der Beschreibung der Katalysatorperformance ist die Verteilung der Edelmetallspezies im Katalysator. In den zuvor hergestellten Ir_{y}Ti_{1-y}O₂-Mischoxidsystemen befindet sich die Mehrzahl der Ir-Spezies im Volumen des Materials und nicht an der Oberfläche in Kontakt mit der Umgebung. Für eine Erhöhung der Effizienz der Katalysatoren ist somit ein neues Konzept der Elektrodenstrukturierung erforderlich.

Das erfindungsgemäße Verfahren stellt somit eine erhebliche Verbesserung des Standes der Technik dar. Das Verfahren erlaubt überraschend vorteilhaft eine verbesserte Ausnutzung der katalytisch aktiven Edelmetallspezies durch einen optimierten Aufbau der Materialien. In bevorzugten Ausführungsformen befindet sich der Großteil der Edelmetallspezies exponiert an der Oberfläche, um mit dem umgebenden Medium, bspw. H₂O im Falle der elektrochemischen Wasserspaltung, interagieren zu können. Bei deutlich reduzierten geometrischen Beladungen an Edelmetall in den Katalysatoren kann eine verbesserte Katalysatorperformance (hohe edelmetallbasierte katalytische Aktivität und erhöhte Elektroden-Stabilität gegenüber dem reinen Trägermaterial mit geringen Ir-Anteilen) erreicht werden.

Vorausgehende Arbeiten, wie beispielsweise Daiane Ferreira da Silva et al. (2021) haben gezeigt, dass IrOₓ-Spezies die beste Performance für die saure OER-Halbzellenreaktion aufweisen. Hartig-Weiss et al. (2020) zeigt in der Publikation, dass unter Verwendung von elektrisch leitfähigen Antimon-dotierten Zinnoxiden (ATO) als Trägermaterialen für katalytisch aktive IrOₓ-Spezies eine deutliche Erhöhung der Ir-massenspezifischen Aktivitäten verglichen mit kommerziell erhältlichen Referenzkatalysatoren basierend auf Ir/TiO₂ oder Ir-black. In der Arbeit wurden die zuvor via Polyol-Syntheseansatz hergestellten OER-aktiven IrOₓ-Nanopartikel von ca. 2 - 3 nm Durchmesser auf der Oberfläche des Trägerpulvers (ATO) aufgebracht. Zwar ist die Verwendung von ATO als elektrisch leitfähiger Träger vorteilhaft für eine hohe OER-Aktivität, jedoch wurde eine unzureichende Stabilität dotierter Zinnoxidmaterialien unter den korrosiven OER-Bedingungen offenbart (siehe auch Geiger et al. (2017)). Der verwendete nanopartikelbasierte Ansatz von Hartig-Weiss et al. (2020) ermöglicht daher keinen ausreichenden Schutz vor Auflösung und/oder Degradation der Katalysatoren, zumal keine oberflächenkonforme Schutzhülle, die den Träger bestmöglich umhüllt, eingeführt wurde.

In diesem Kontext bietet das Verfahren der ALD entscheidende Vorteile. ALD ermöglicht bei geeigneter Wahl der Reaktionsparameter vorteilhaft die Ausbildung homogener, ultradünner Atomlagen im Bereich weniger nm. Insbesondere die Temperatur der ALD-Reaktion ist entscheidend für die resultierende Phase, Zusammensetzung sowie die Kristallinität der Beschichtung. Darüber hinaus wurden verschiedene ALD-Präkursoren eingesetzt, um die Nukleation sowie das Wachstumsverhalten der abgeschiedenen Dünnschichten zu verändern.

Bevorzugt wird (EtCp)Ir^{l}(CHD) (Ethylcyclopentadienyl-1,3-cyclohexadieniridium(I)) als Präkursor für die Abscheidung von Ir-Edelmetallspezies in Kombination mit in-situ erzeugtem Ozon (O₃) identifiziert. Es gilt hinzuzufügen, dass auch unter Verwendung einer alternativen Verbindung, Iridium(III)-acetylacetonat (Ir(acac)₃), aktive OER Katalysatoren mithilfe von ALD auf porösen Ir_{y}Ti_{1-y}O₂-Trägermaterialien erhalten werden konnten. Vorteilhafterweise weist (EtCp)Ir^{I}(CHD) insbesondere einen höheren Dampfdruck auf, was bei Gasphasenreaktionen besonders reaktionseffizient ist.

Der Einsatz von nanostrukturierten, porösen Trägermaterialien für die katalytisch aktive Edelmetallspezies, welche mittels ALD abgeschieden werden, hat sich als besonders vorteilhaft erwiesen. Die Trägermaterialien befinden sich dabei bspw. in der Form dünner Beschichtungen auf geeigneten Metallgittern, z. B. Titan.

Der Einsatz von Modellschichtsystemen mit definierter mesoporöser Porenstruktur (hergestellt z. B. durch Tauchbeschichten) ermöglicht gezielte Untersuchungen der strukturellen sowie elektronischen Wechselwirkungen zwischen Trägermaterial und abgeschiedener Oberflächenspezies via ALD. Die erfindungsgemäßen Ergebnisse der elektrischen Leitfähigkeitsuntersuchungen geeigneter Trägermaterialien zeigen einen deutlichen Anstieg der Leitfähigkeit titanoxidbasierter Modellschichtsysteme durch den Einbau geringer Mengen Edelmetall, bspw. Ir oder Ruthenium (Ru). In gleichem Maße wurde ein drastischer Aktivitätsanstieg in der sauren OER-Katalyse für Ir_{y}Ti_{1-y}O₂-Trägermaterialien mit einem Minimum von 15 mol-% Ir im Mischoxid beobachtet. Mischoxide mit geringeren relativen Anteilen zwischen 0-15 mol-% Ir in Ir_{y}Ti_{1-y}O₂ zeigen geringe katalytische Aktivitäten. Mithilfe von edelmetallbasierter ALD lässt sich der Gesamtanteil an aktivem Edelmetall geringfügig steigern, wodurch die katalytische Aktivität insgesamt zunehmen sollte. Ein Aktivitätsvorsprung konnte jedoch nur im Falle der Verwendung von ausreichend leitfähigen Trägermaterialien beobachtet werden, für die ein Minimum von 15 mol-% Ir im Ir_{y}Ti_{1-y}O₂-Träger erforderlich ist.

In einer weiteren bevorzugten Ausführungsform ist das Verfahren dadurch gekennzeichnet, dass das Trägermaterial mit der katalytisch aktiven Edelmetallspezies bei einer Temperatur von T₁ = ca. 120 °C mittels Atomlagenabscheidung modifiziert (d. h. insbesondere beschichtet) wird, wobei bevorzugt eine Schichtdicke von durch die Atomlagenabscheidung abgeschiedenen Atomlagen durch eine Anzahl an Zyklen, Pulsdauern und/oder eingesetzten Präkursoren eingestellt werden kann.

Die Abscheidung von IrOₓ-Spezies begünstigt überraschend und vorteilhaft sowohl die katalytische Aktivität als auch die Stabilität verglichen mit reinen Ir_{y}Ti_{1-y}O₂-Trägern in der sauren OER-Katalyse. Durch eine gezielte Optimierung der ALD-Parameter lässt sich vorteilhaft die intrinsische Aktivität der eingeführten oberflächennahen Edelmetallspezies erhöhen. Bei einer bevorzugten Temperatur von T₁ = ca. 120 °C in der ALD-Reaktionskammer wird die Abscheidung von konformen Atomlagen oxidischer IrOₓ-Spezies erreicht, welche zu höheren edelmetallspezifischen Massenaktivitäten als eine ALD bei bspw. T₂ = ca. 160 °C führt, bei der hauptsächlich metallische Ir⁽⁰⁾-Spezies gebildet werden. Außerdem beeinflusst überraschenderweise die Temperatur während der ALD die Morphologie und Konformität der abgeschiedenen Spezies bzw. Beschichtung. Es war überraschend, dass eine Temperatur von ca. 120 °C sich als besonders vorteilhaft erwiesen hat.

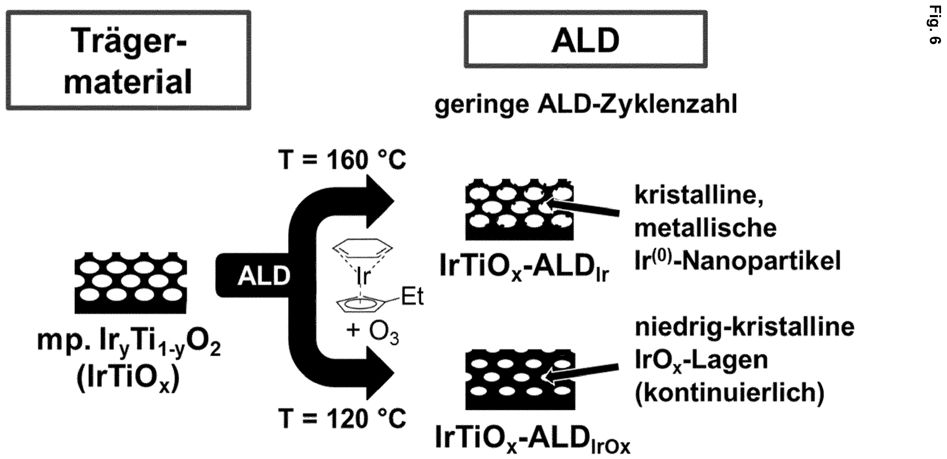

So wurde festgestellt, dass beispielsweise eine Temperatur von T₂ = ca. 160 °C zu einer eher feinen Verteilung der katalytisch aktiven Edelmetallspezies führte entlang von Poren eines porösen Trägermaterials. Hingegen konnte bei einer Temperatur von T₁ = ca. 120 °C eine dichte Verteilung entlang der Poren eines porösen Trägermaterials (siehe auch Fig. 6).

Im Rahmen der vorliegenden Erfindung wurden hohe elektrische Leitfähigkeiten nach der Abscheidung ausreichend hoher Mengen gut leitfähiger IrOₓ-Spezies erreicht. Ein weiterer besonders vorteilhafter Effekt ist eine merklich verbesserte Stabilität für IrOₓ-ALD-beschichtete Ir_{y}Ti_{1-y}O₂-Trägermaterialien in saurer, oxidativer Umgebung. Diese lässt sich auf die Ausbildung einer homogenen und konformen Schutzhülle von elektrokatalytisch aktiven und stabilen IrOₓ-Atomlagen um die gesamte zugängliche Oberfläche des Trägers zurückführen. Für die Entwicklung von effizienten und wirtschaftlichen Katalysatorsystemen sind sowohl eine hohe Aktivität als auch eine ausreichende Langzeitstabilität von großer Bedeutung. Vorteilhaft wird diese gesteigerte Katalysatorperformance durch das erfindungsgemäße Verfahren erreicht.

In einer weiteren bevorzugten Ausführungsform wird die ALD innerhalb von ca. 10, 20, 30, 40, 50, 60, 70, 80 oder mehr Zyklen durchgeführt. Je höher die Anzahl der Zyklen ist, desto dickere Schichtdicken können aufgetragen werden. Mit zunehmender Schichtdicke kann vorteilhaft die elektrische Leitfähigkeit erhöht werden. Weiterhin wird mit zunehmenden Zyklen der ALD der Durchmesser der Poren, die das Trägermaterial in bevorzugten Ausführungsformen aufweisen kann, verkleinert.

In weiteren bevorzugten Ausführungsform setzt sich ein Gesamtzyklus einer ALD aus zwei Teilzyklen (ein Teilzyklus für den Edelmetall-Präkursor, sowie ein Teilzyklus für den Sauerstoff-Präkursor) zusammen. Vorteilhafterweise beträgt die Pulsdauer der Edelmetall-Präkursorverbindung ca. 0,80 s, gefolgt von einer ca. 40-sekündigen Exposition und nachfolgendem ca. 20-sekündigem Spülvorgang der Kammer mit einem Inertgas (bevorzugt N₂). Dieser Prozess wird wiederholt (erster Teilzyklus), bevor die Oxidation der an der Oberfläche adsorbierten Edelmetallspezies durch Einleiten eines geeigneten Sauerstoff-Präkursors (bevorzugt O₃) erfolgt (zweiter Teilzyklus). Vorteilhafterweise beträgt die Pulsdauer des Sauerstoff-Präkursors ca. 0,25 s, gefolgt von einer ca. 45-sekündigen Exposition und nachfolgendem ca. 30-sekündigem Spülvorgang der Kammer mit einem Inertgas (bevorzugt N₂). Der gesamte hier beschriebene Vorgang stellt einen ALD-Zyklus dar.

In einer weiteren bevorzugten Ausführungsform ist das Verfahren dadurch gekennzeichnet, dass das Trägermaterial bevorzugt eine Oberfläche zwischen ca. 50 und ca. 500 m²/m²_{geom.Substratfläche} aufweist, bevorzugt zwischen 100 und 200 m²/m²_{geom.Substratfläche}, und/oder das Trägermaterial eine elektrische Leitfähigkeit zwischen ca. 10⁻³ und ca. 10² S/cm aufweist, bevorzugt zwischen 10⁻³ und 10⁻² S/cm.

Die Schreibweise m²/m²_{geom.Substratoberfläche} meint bevorzugt ein relatives Verhältnis der gesamten zugänglichen Oberfläche eines porösen Materials in Form einer dünnen Schicht bzw. Beschichtung auf einem Substrat zu der Oberfläche des Substrats. In diesem Kontext erfolgt eine flächenspezifische Normierung der Oberfläche der Schicht bzw. Beschichtung auf die geometrische Fläche des darunterliegenden Substrats, welche sich insbesondere für dünne, templatiert (meso)poröse Schichten als vorteilhaft erwiesen hat und eine Vergleichbarkeit verschiedener (Träger)materialien mit ähnlichen Schichtdicken ermöglicht. Unter Einbeziehung weiterer Parameter der porösen Schicht bzw. Beschichtung, wie u. a. der Schichtdicke orthogonal zur Substratebene und/oder der Dichte des Materials, kann eine volumen- bzw. massenspezifische Angabe der Oberfläche des Trägermaterials erfolgen.

In einer weiteren bevorzugten Ausführungsform ist das Verfahren dadurch gekennzeichnet, dass ein Edelmetall im Trägermaterial ausgewählt ist aus einer Gruppe umfassend Platinmetalle und/oder einen Anteil zwischen ca. 5 - 75 Gew.-% umfasst, bevorzugt Ir-Edelmetall mit einem relativen Anteil zwischen 25 - 35 Gew.-% im Trägermaterial.

In einer weiteren bevorzugten Ausführungsform ist das Verfahren dadurch gekennzeichnet, dass ein Edelmetall mithilfe von Atomlagenabscheidung auf einer gesamten inneren und äußeren Oberfläche beschichtet wird, wobei bevorzugt das Edelmetall ausgewählt ist aus der Gruppe der Platinmetalle. Vorzugsweise werden dabei die gesamte zugängliche Porenwandstruktur bzw. Materialoberfläche des Trägers einschließlich aller zugänglichen Hohlräume modifiziert. Das Verfahren bietet die Möglichkeit, nicht nur die leicht zugängliche, äußere Oberfläche (Trägerschicht) zu beschichten, sondern auch das gesamte innere Porensystem einschließlich aller tiefer in der Schicht befindlichen Porenwände mit Ausnahme unzugänglicher geschlossener, nicht vernetzter Poren.

In einer weiteren bevorzugten Ausführungsform ist das Verfahren dadurch gekennzeichnet, dass ein auf das Trägermaterial abgeschiedenes Edelmetall in Form einer reduzierten oder oxidierten Spezies vorliegt, bevorzugt in Form eines amorphen und/oder niedrig-kristallinen Metalloxides, wobei bevorzugt in Form niedrig-kristalliner oxidischer IrOₓ-Spezies mit einer bevorzugten Oxidationsstufe für den überwiegenden Anteil der Ir-Atome von +3 (Ir^{III+}), um die elektronischen und, damit einhergehend, katalytischen Eigenschaften vorteilhaft zu beeinflussen.

In einer weiteren bevorzugten Ausführungsform ist das Verfahren dadurch gekennzeichnet, dass das Trägermaterial und/oder eine abgeschiedene Oberflächenschicht ein oder mehrere Edelmetallspezies aufweist, bevorzugt Kombinationen aus Iridium und/oder Ruthenium und/oder Platin im Trägermaterial sowie Kombinationen aus Iridium und/oder Ruthenium und/oder Platin in der Oberflächenschicht.

In einer weiteren bevorzugten Ausführungsform ist das Verfahren dadurch gekennzeichnet, dass eine Temperatur bei der Atomlagenabscheidung in Abhängigkeit der eingesetzten Präkursorverbindungen zwischen ca. 25 °C und ca. 350 °C liegt, bevorzugt zwischen 110 °C - 130 °C.

In einer weiteren bevorzugten Ausführungsform sind die Präkursoren ausgewählt aus einer Gruppe umfassend (EtCp)Ir^{l}(CHD) (Ethylcyclopentadienyl-1,3-cyclohexadieniridium(I)) für die Abscheidung von Ir-Edelmetallspezies in Kombination mit in-situ erzeugtem Ozon (O₃). Auch unter Verwendung einer alternativen Verbindung, wie z. B. Iridium(III)acetylacetonat (Ir(acac)₃), konnten vorteilhaft aktive OER Katalysatoren mithilfe von ALD bei 200 °C auf Ir_{y}Ti_{1-y}O₂-Trägermaterialien erhalten werden. Vorteilhafterweise weist (EtCp)Ir^{l}(CHD) insbesondere einen höheren Dampfdruck auf, was insbesondere bei Gasphasenreaktionen besonders reaktionseffizient ist.

In einer weiteren bevorzugten Ausführungsform ist das Verfahren dadurch gekennzeichnet, dass eine auf das Trägermaterial abgeschiedene Schicht eine Dicke zwischen ca. 0,1 - 25 nm aufweist, bevorzugt zwischen ca. 1 - 4 nm orthogonal zur modifizierten Oberfläche.

Die Abscheidung edelmetallbasierter Oberflächenlagen beeinflusst die elektrischen Eigenschaften der Materialien vorteilhaft. Insbesondere lässt sich bereits durch die Einführung geringer Schichtdicken der abgeschiedenen Oberflächenlagen eine deutliche Erhöhung (bis zu Faktor 10⁵) der elektrischen Leitfähigkeit des gesamten Materials erzielen, welche vorteilhaft für die katalytischen Eigenschaften (insbesondere Aktivität) ist. In Abhängigkeit des mittleren Porendurchmessers des Trägermaterials sind zu hohe aufgebrachte Schichtdicken unvorteilhaft, da diese die spezifische Oberfläche des Materials verringern und, gegebenenfalls, zu einem unerwünschten Blockieren des Porensystems führen können.

In einer weiteren bevorzugten Ausführungsform ist das Verfahren dadurch gekennzeichnet, dass nach der Beschichtung der katalytisch aktiven Edelmetallspezies mittels Atomlagenabscheidung eine thermische Behandlung erfolgt, wobei bevorzugt während der thermischen Behandlung eine Temperatur zwischen ca. 325 °C - 475 °C erfolgt, wobei bevorzugt eine Zeitspanne zwischen 1 - 300 min beträgt, wobei besonders bevorzugt die thermische Behandlung in einer Luftatmosphäre erfolgt.

Die thermische Behandlung entfernt vorteilhafterweise Überreste der während des ALD-Vorgangs eingesetzten Präkursorverbindungen (z. B. Kohlenstoff-haltige Fragmente) und sorgt für eine milde thermische Oxidation der abgeschiedenen edelmetallbasierten Lagen. Es werden bevorzugt niedrig-kristalline IrOₓ-Spezies gebildet, welche eine vorherrschende Oxidationsstufe von +3 (Ir^{III+}) aufweisen, ohne dass Sintervorgänge eingeleitet werden. In diesem Kontext lässt sich eine vorteilhafte Steigerung der elektrischen Leitfähigkeit der Materialien infolge der thermischen Behandlung erreichen, welche sich wiederum vorteilhaft auf die katalytischen Eigenschaften (Aktivität als auch Stabilität) auswirkt.

In einem weiteren Aspekt betrifft die Erfindung eine Verwendung des mittels der Atomlagenabscheidung oberflächenmodifizierten Trägermaterials als Katalysatoren und/oder Katalysatorträger, im Bereich von Photovoltaik, in einer Elektrokatalyse, in einer Photo(elektro)katalyse, in chemischen Hydrierungs-, Alkylierungs- oder Kupplungsreaktionen, in der Medizintechnik, im Maschinenbau, im Bereich einer Optik und/oder Optoelektronik, als Energiespeicher und/oder im Bereich einer Schmuckindustrie.

Begriffe wie ca., im Wesentlichen, etwa, etc. beschreiben bevorzugt einen Toleranzbereich von weniger als ± 40 %, bevorzugt weniger als ± 20 %, besonders bevorzugt weniger als ± 10 %, noch stärker bevorzugt weniger als ± 5 % und insbesondere weniger als ± 1 % und umfassen insbesondere den exakten Wert.

Das erfindungsgemäße Verfahren soll im Folgenden anhand von Beispielen näher erläutert werden, ohne auf diese Beispiele beschränkt zu sein.

### FIGUREN

### Kurzbeschreibung der Abbildungen

- **Fig. 1**: Schematische Darstellung des Prinzips der Oberflächenmodifikation von elektrisch leitfähigen Ir_{y}Ti_{1-y}O₂-Mischoxid-basierten Trägermaterialien mit katalytisch aktiven IrOₓ-Spezies mittels Atomlagenabscheidung (ALD)
- **Fig. 2**: Übersicht des entwickelten ALD-Prozesses
- **Fig. 3**: REM-Aufnahme von hergestellten Ir_{y}Ti_{1-y}O₂-Schichten vor bzw. nach der IrOₓ-ALD in Draufsicht auf einem Siliziumwafer als Substrat
- **Fig. 4**: Ergebnisse der Stabilitätstestungen via Chronopotentiometrie
- **Fig. 5**: Ergebnisse einer elektrokatalytischen Stabilitätsmessung
- **Fig. 6**: Schematische Darstellung der Oberflächenmodifikation mit unterschiedlichen Temperaturbereichen beim ALD
- **Fig. 7**: Ergebnisse von elektrokatalytischen Performancetestungen eines IrOₓ-oberflächenmodifizierten Ir/TiO₂-Katalysatorpulvers in einem PEM-Elektrolyseuraufbau
- **Fig. 8**: REM-Aufnahmen unbeschichteter sowie beschichteter und anschließend ALD-modifizierter dreidimensionaler, makroskopisch poröser Substrate als OER-Elektroden
- **Fig. 9**: Ergebnisse von elektrokatalytischen Performancetestungen in einem PEM-Elektrolyseur-Aufbau bei 80° C unter Nutzung einer Elektrode (Anode) umfassend einer IrOₓ-oberflächen-modifizierten, mesoporösen Ir_{y}Ti_{1-y}O₂-Mischoxidschicht, abgeschieden auf einem elektrisch leitfähigen Titan-Gitter als Substrat

### Detaillierte Beschreibung der Figuren

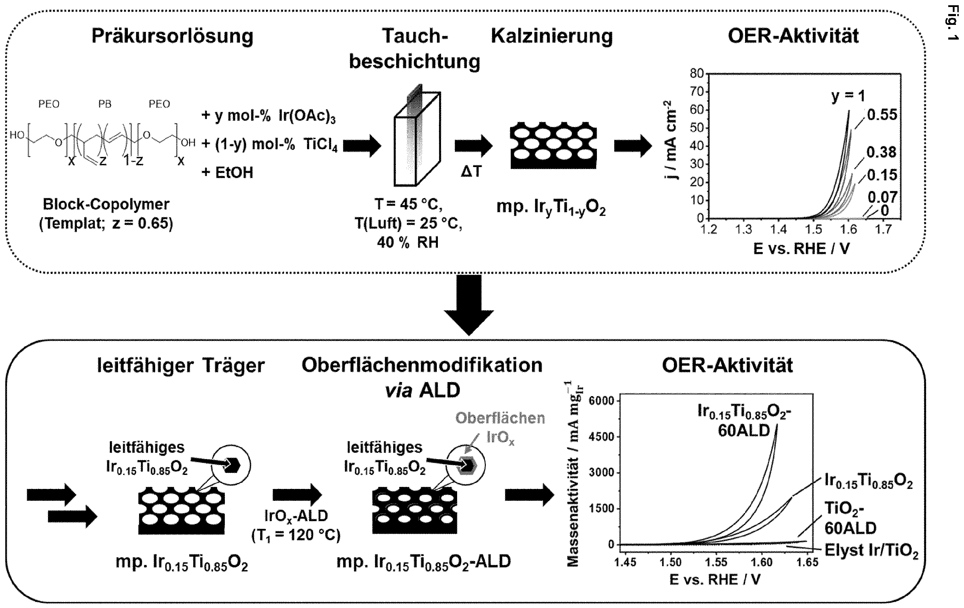

**Fig. 1** zeigt eine schematische Darstellung des Prinzips der Oberflächenmodifikation, der bereits im Stand der Technik bekannt und wie es gemäß der Erfindung bevorzugt ist. Im oberen Kasten wird für die Herstellung aktiver Katalysatorschichten auf Basis von Ir_{y}Ti_{1-y}O₂-Mischoxiden (wobei der Parameter y zwischen 0 und 1 liegt) für die elektrochemische Wasserspaltung (saure OER, engl. oxygen evolution reaction) mittels Tauchbeschichtung. Die Mischoxidschichten werden auf geeigneten Substraten abgeschieden und weisen eine geordnete, templatiert mesoporöse Strukturierung infolge einer thermischen Behandlung unter Luftatmosphäre auf. Für eine ausreichend hohe elektrische Leitfähigkeit und OER-Aktivität ist ein Gehalt von mindestens y = 15 mol-% Ir (= 30 Gew.-%) im Mischoxid nötig.

Das neu entwickelte Synthesekonzept (unten) nutzt die auf diese Weise hergestellten Ir_{y}Ti_{1-y}O₂-Mischoxidschichten als leitfähige Trägermaterialien für die kontrollierte Oberflächenmodifizierung mit hoch aktiven IrOₓ-Spezies mittels Atomlagenabscheidung (ALD). Besonders bevorzugt beträgt die Zusammensetzung des Trägermischoxids Ir_{0.15}Ti_{0.85}O₂, um eine ausreichende Leitfähigkeit sicherzustellen. Die Temperatur der ALD beträgt vorzugsweise T₁ = 120 °C, um die Erzeugung oberflächenkonformer IrOₓ-Lagen zu ermöglichen. Dabei wird die gesamte innere und äußere Oberfläche modifiziert. Die berechneten potentialabhängigen Ir-massenspezifischen Aktivitäten übersteigen die des reinen Ir_{0.15}Ti_{0.85}O₂-Trägers sowie die eines oberflächenmodifizierten TiO₂-Trägers als auch einer kommerziellen Referenz (Elyst Ir75 0480, 75 Gew.-% Ir, Umicore) deutlich. Die erhaltenen Materialien weisen überraschend sowohl eine verbesserte massenspezifische Aktivität pro Edelmetallgehalt als auch eine höhere katalytische Stabilität auf.

**Fig. 2** zeigt eine schematische Darstellung der neu entwickelten ALD-Prozedur zur Abscheidung kontrollierter Atomlagen umfassend IrOₓ bei T₁ = 120 °C unter Verwendung von (EtCp)Ir^{I}CHD sowie in-situ generiertem O₃. Nach der Stabilisierung des Reaktorsetups erfolgt ein Aufreinigungs- bzw. Oberflächenfunktionalisierungsschritt, welcher zehn Zyklen umfasst und O₃ als aktive Spezies nutzt. Anschließend erfolgt die Abscheidung von IrOₓ-Atomlagen in zwei wiederholt durchgeführten Halb-Zyklen.

Bei der ALD wurde der Edelmetall-Präkursor 1-Ethylcyclopentadienyl-1,3-cyclohexadien-iridium(I) (abcr GmbH, 99 %) ohne weitere Aufreinigung eingesetzt. Ozon wurde ausgehend von Sauerstoff (Air Liquide, 99 %) *in-situ* in einem Ozongenerator (AC-2025, Teledyne API) hergestellt. Stickstoff und Argon wurden von Air Liquide mit einer Reinheit von 99,9 % erworben und als Inertgas eingesetzt.

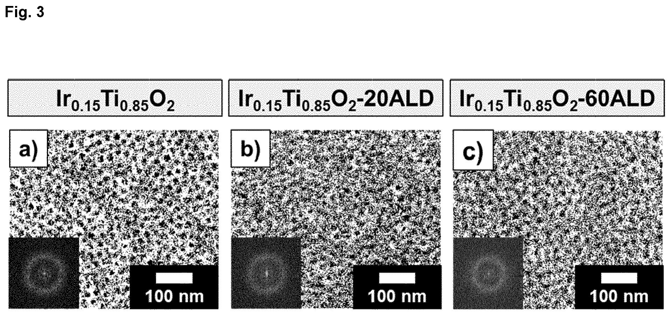

**Fig. 3** bildet rasterelektronenmikroskopische (REM) Aufnahmen in Draufsicht auf (a) einen durch Tauchbeschichtung hergestellten mesoporös templatierten Ir_{y}Ti_{1-y}O₂-Film (y = 15 mol-% Ir) nach einer Kalzinierung für ca. 10 min bei ca. 375 °C unter Luftatmosphäre auf einem Siliziumwafer als Substrat ab. Der isotrope Ring im Fast-Fourier-Transform (FFT) der zugehörigen REM-Aufnahme legt eine lokale Ordnung der Poren nahe. (b) & (c) zeigen REM-Aufnahmen nach der Atomlagenabscheidung unter Variation der eingesetzten Anzahl an Zyklen (b: 20 ALD-Zyklen, c: 60 ALD-Zyklen). Die Abscheidung erfolgte bei ca. T₁ = 120 °C unter Verwendung von (EtCp)Ir^{I}CHD sowie Ozon (O₃) als Präkursoren oder Präkursorverbindungen. Der mittlere Porendurchmesser nimmt annähernd linear mit der Anzahl an ALD-Zyklen ab. Der konforme Charakter der ALD wird deutlich, zumal die eingeführte poröse Struktur des Trägermaterials nach der Abscheidung erhalten bleibt (siehe FFTs in (b) & (c)).

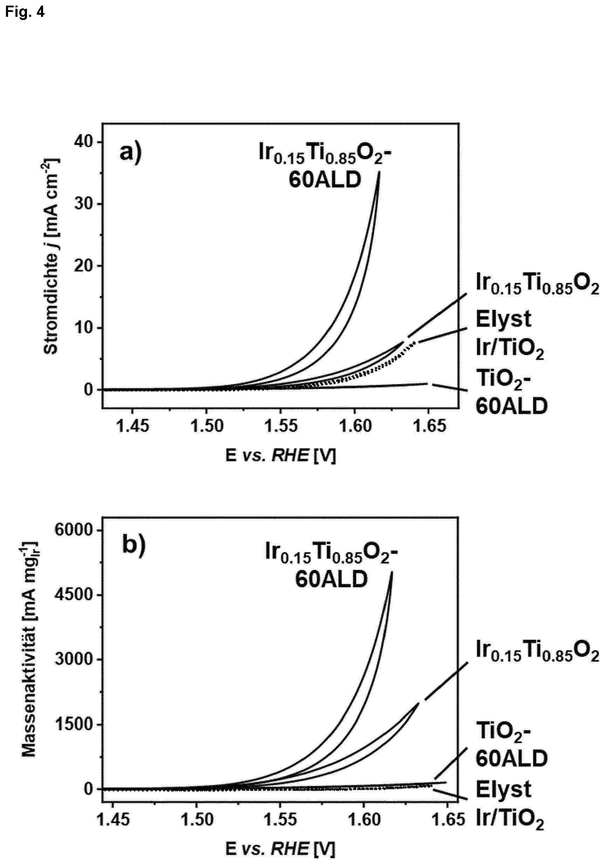

**Fig. 4** (a) stellt elektrokatalytische Aktivitätsmessungen (Cyclovoltammetrie) der Sauerstoffbildungsreaktion (OER) in einem rotierenden Scheibenelektrodenaufbau in 0,5 M Schwefelsäure als Elektrolyten bei 25 °C. Dargestellt sind die Stromdichten verschiedener Katalysatorbeschichtungen bei einem bestimmten angelegten Potential (gegen RHE (reversible Wasserstoffelektrode, engl. reversible hydrogen electrode); *iR*-korrigiert) im OER-Regime. Als Katalysatorbeschichtungen wurden mesoporös templatiertes Ir_{0.15}Ti_{0.85}O₂ sowie IrOₓ-ALD-modifiziertes Ir_{0.15}Ti_{0.85}O₂-60ALD untersucht. Als Referenz wurde ein edelmetallfreies TiO₂ in Form einer mesoporös templatierten Schicht mittels Tauchbeschichtung hergestellt und als schlecht leitfähiges Trägermaterial mit derselben ALD-Prozedur modifiziert (TiO₂-60ALD). Die ALD erfolgte bei T₁ = 120 °C. Zudem wurde ein kommerziell erhältliches Katalysatorpulver mit einem Gehalt von 74,7 % Gew.-% Ir in Ir/TiO₂ nach der Herstellung eines Katalysator-Inks unter der Zugabe von Nafion-Binder als Referenz getestet. Alle untersuchten Schichten wurden auf einem polierten Titanblech als Substrat vermessen. Nach der Abschätzung des jeweiligen Ir-Gehalts in den Katalysatorschichten resultieren Graphen für eine potentialabhängige Irspezifische OER-Massenaktivität (b).

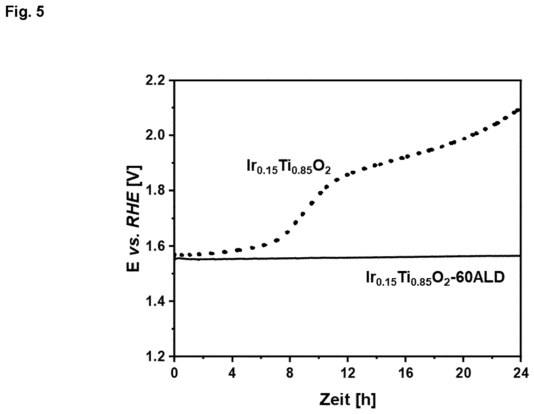

**Fig. 5** präsentiert Ergebnisse von elektrokatalytischen Stabilitätsmessungen (Chronopotentiometrie bei einer Stromdichte von j = 1 mA/cm²) der Sauerstoffbildungsreaktion (OER) in einem rotierenden Scheibenelektrodenaufbau in 0,5 M Schwefelsäure als Elektrolyten bei 25 °C. Dargestellt sind die Ergebnisse des Potentials (gegen RHE) von hergestellten mesoporös templatierten Ir_{y}Ti_{1-y}O₂ (y = 15 mol-% Ir) sowie IrOₓ-ALD-modifizierten Ir_{0.15}Ti_{0.85}O₂-60ALD Schichten. Die ALD erfolgte bei T₁ = 120 °C. Die untersuchten Schichten wurden auf einem polierten Titanblech als Substrat hergestellt und vermessen. Ir_{0.15}Ti_{0.85}O₂-60ALD weist eine deutlich verbesserte katalytische Stabilität während der gesamten 24 Stunden (h) im sauren Elektrolyten auf.

**Fig. 6** zeigt die Ordnung von IrOₓ auf mit IrTiOₓ modifiziertes Oberflächenmaterial. So konnten vorteilhaft und völlig überraschend und erwartet die Erfinder mit einer Vielzahl von Experimenten herausfinden, dass bei einer Temperatur von 120 °C eine besonders geeignete und effiziente Oberflächenmodifizierung erlangt werden kann.

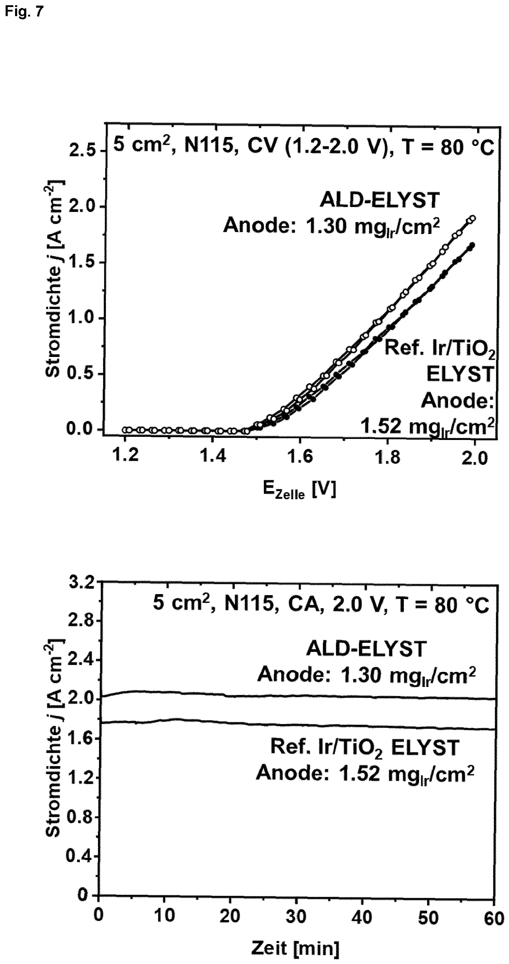

**Fig. 7** stellt Ergebnisse hinsichtlich der Skalierung des Konzepts sowie die Übertragung auf pulverförmige Materialien anhand von Messungen in einem PEM-Elektrolyseur-Aufbau im Labormaßstab dar. Dabei werden Katalysatoraktivität sowie -stabilität eines mittels IrOₓ-oberflächenmodifizierten Benchmark-Katalysatorpulvers für die limitierende Anodenseite (Ir/TiO₂, 74,7 Gew.-% Ir; Elyst Ir75 0480; Umicore) mit der des unmodifizierten, kommerziell erhältlichen, Katalysatormaterials verglichen. Sowohl für die Referenz als auch das modifizierte Katalysatorpulver wurde eine Membran-Elektroden-Einheit (MEA, membrane electrode assembly) *via* Spray-Coating homogenisierter Katalysator-Inks hergestellt. Als protonenleitende Membran wurde Nafion vom Typ N115 (127 µm Dicke) verwendet, für die Kathodenseite wurde Pt/C (46,7 Gew.-% Pt; Vulcan-Kohlenstoff) eingesetzt (Beladung ca. 0,35 mg_{Pt}/cm²). Bei 80 °C weist die MEA mit dem oberflächenmodifizierten OER-Katalysatormaterial eine verbesserte Aktivität sowie hohe Stabilität auf. Eine verringerte Edelmetallbeladung auf der Anodenseite führt im Vergleich zum Benchmark-Katalysator (ELYST) überraschenderweise zu höheren Stromdichten im Elektrolyseur. Eine um etwa 20 % gesteigerte Iridium-massenspezifische OER-Aktivität verglichen mit dem unmodifizierten Benchmark-Katalysatorpulver wird infolge der Oberflächenmodifizierung vorteilhafterweise erreicht.

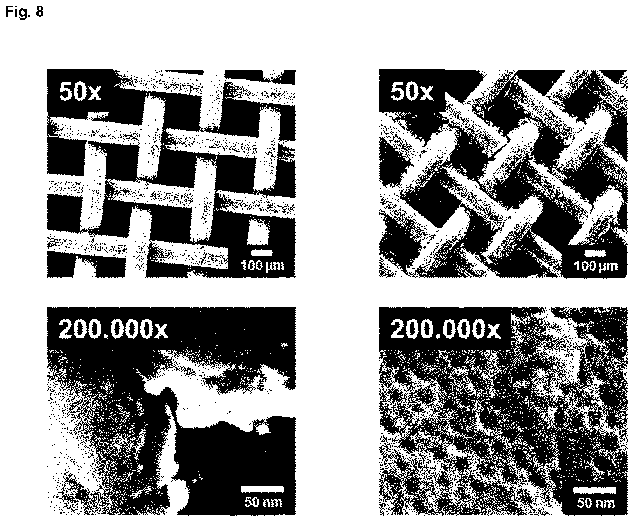

**Fig. 8** zeigt repräsentative rasterelektronenmikroskopische Aufnahmen der unmodifizierten Oberfläche eines ausgewählten, kommerziell erhältlichen Titan-Gitters als elektrisch leitfähiges Substrat mit dreidimensionaler Strukturierung (linke Spalte), sowie die mittels Tauchbeschichtung und ALD modifizierte Oberfläche (IrOₓ-ALD-modifizierte Ir_{0.15}Ti_{0.85}O₂-60ALD Beschichtung auf Titan-Gitter, rechte Spalte). Das entwickelte Verfahren, basierend auf der Kombination von Tauchbeschichtungs- sowie ALD-Vorgang, ermöglicht die Herstellung definiert poröser Katalysatorschichten auf der gesamten exponierten Substratoberfläche. Das beschichtete und IrOₓ-ALD-modifizierte, dreidimensional strukturierte Titan-Gitter weist eine hierarchische Porenstruktur umfassend Meso- (nm) sowie Makroporen (µm) auf.

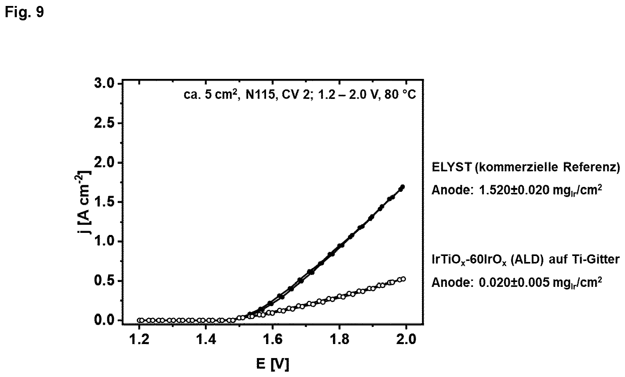

**Fig. 9** präsentiert Ergebnisse von elektrokatalytischen Aktivitätsmessungen (Cyclovoltammetrie bei 80 °C) in einem PEM-Elektrolyseur-Aufbau im Labormaßstab (aktive geometrische Fläche der Elektroden von bis zu 5 cm²). Das beschichtete und IrOₓ-ALD-modifizierte, dreidimensional strukturierte Titan-Gitter wurde auf der Anodenseite der hergestellten MEA (CCS, catalyst coated substrate) verwendet (Beladung ca. 0,020 mg_{Ir}/cm²; graue Kurve). Für die Kathodenseite wurde Pt/C (46,7 Gew.-% Pt; Vulcan-Kohlenstoff) eingesetzt (Beladung ca. 0,28 mg_{Pt}/cm²). Für die Herstellung der MEA der neu entwickelten Katalysatorbeschichtung *via* CCS wurde ebenfalls eine kommerziell erhältliche, protonenleitende Nafion-Membran vom Typ N115 (127 µm Dicke) verwendet. Das beschichtete Gitter wurde bei 150 °C für 90 s mit einem Druck von etwa 1000 psi heiß an die Membran gepresst ("hot-pressing"), um eine bessere Anbindung der modifizierten Irreichen Oberfläche zu erreichen. In einer bevorzugten Ausführungsform wurde vor diesem Schritt in Isopropanol gelöstes Nafion-Ionomer ("Binder") kontrolliert auf die Gitter-Oberfläche gesprüht (3 Lagen, 1,0 Gew.-% Nafion Lösung, ca. 75 µgᵢₒₙₒₘₑᵣ/cm²). Anschließend wurde die Pt/C-Kathode *via* Sprühbeschichtung ("spray-coating") eines hergestellten lonomer-haltigen Katalysator-Inks auf der gegenüberliegenden Seite der Membran bei 60 °C aufgebracht. Als Referenz sind die Ergebnisse einer hergestellten MEA (CCM, catalyst coated membrane) basierend auf kommerziell erhältlichem Benchmark-Katalysatorpulver (Elyst Ir75 0480, Ir/TiO₂, Umicore) als Anodenmaterial gegeben (Beladung ca. 1,520 mg_{Ir}/cm²). Unter Berücksichtigung der etwa um einen Faktor von 75 geringeren geometrischen Ir-Beladung, wird eine um ca. 15-20-fach erhöhte edelmetallspezifische OER-Massenaktivität (2,0 V Zellspannung) im Vergleich zum kommerziellen Benchmark-Katalysator erreicht.

### Eingesetzte Messmethoden

Die morphologischen und strukturellen Eigenschaften der Trägermaterialien wurden vor sowie nach der Oberflächenmodifikation via ALD mittels Rasterelektronmikroskopie (REM, *JEOL JSM-7401F*) bei einer Anregungsspannung von ca. 10 kV untersucht. Für eine Abschätzung der mittleren Schichtdicke des gesamten porösen Films auf einem bestimmten Substrat wurden Querschnittsaufnahmen aufgenommen und ausgewertet. Untersuchungen in einem Transmissionselektronenmikroskop (TEM, *FEI Talos*, 200 kV Beschleunigungsspannung) lieferten weitere morphologische als auch strukturelle Informationen. Für die Präparation der Proben wurden im Falle der Schichten mit einem Diamantkratzer vorsichtig winzige Fragmente abgekratzt und auf mit Kohlenstoff-beschichteten Kupfer-Gittern (sogenannte TEM grids) abgeschieden.

EDX-Messungen (Energiedispersive Röntgenspektroskopie) in einem REM und/oder TEM wurden für eine qualitative und/oder quantitative Bestimmung der enthaltenen Elemente herangezogen. Dabei wurde ein *Quantax 400* Röntgenspektrometer (*Bruker*, energiedispersiv) gekoppelt mit einem Elektrometer vom Typ 6517B (*Keithley*) für eine Bestimmung des durchschnittlichen Probenstroms in einem REM eingesetzt. Alternative wurde die Methode der induktiv-gekoppelten Plasma-Emissionsspektroskopie (ICP-OES, *Varian 715 ES*, radial, CCD-Detektor) für eine Bestimmung der geometrischen Edelmetallbeladungen, insbesondere von Iridium, in den Materialien eingesetzt. Die Filme wurden in einer Mischung aus Salzsäure (3,0 mL, Carl Roth, 37 %), Salpetersäure (1,0 mL, Carl Roth, 69 %), Schwefelsäure (1,0 mL, Carl Roth, 96 %) und Natriumchlorat (20,0 mg, Alfa Aesar, 99 %) unter Einsatz von Ultraschall bei 30 °C für mindestens 2 h aufgelöst und nach einer Kalibrierung des Geräts analysiert.

Die vorliegenden Phasen der Materialien wurden mithilfe von Röntgendiffraktometrie in gleisendem Einfall (GI-XRD, *Bruker D8 Advance*, Cu-Ka) charakterisiert. Außerdem wurde für eine lokale Phasenanalyse die Technik der Elektronendiffraktion (SAED) in einem TEM eingesetzt.

Die spezifische Oberfläche der Filme wurde mittels Krypton-Physisorption bei 77 K (*Autosorb-iQ*, *Quantachrome;* mit flüssigem Stickstoff gekühlt) und Normierung auf die beschichtete Substratfläche (poliertes Silizium) untersucht. Für die Auswertung der Daten wurde die dem Fachmann bekannte BET-Methode angewendet.

Die elektrischen Eigenschaften der Schichten wurden mittels Impedanzspektroskopie untersucht. Die Messungen erfolgten in einem Aufbau unter Einsatz eines 8 × 8 Gold-Arrays als leitfähigem Messkopf mit alternierender Polarität. Ein Potentiostat (*SP-200*, *Biologie*) wurde zur Signal-Anregung sowie -Auswertung in einem Bereich zwischen 100 mHz - 1 kHz eingesetzt.

Für elektrochemische Testungen in einem RDE-Aufbau wurden 0,5-molare Schwefelsäure (Fixanal, *Fluka Analytical*) als Elektrolyt und Platin als Gegenelektrode (*Chempur*, Drahtdurchmesser ca. 0,06 mm, 99,9 % Reinheit) verwendet. Eine reversible Wasserstoffelektrode (RHE, *Gaskatel, HydroFlex*) wurde eingesetzt und die Temperatur betrug ca. 25° C. Die Arbeitselektrode (Katalysatormaterial auf flachem, poliertem Titan-Blech) wurde mit ca. 1600 Umdrehungen pro Minute rotiert. Bei den Cyclovoltammetrie-Messungen wurde eine Scan-Rate von 6 mV/s gewählt.

### LITERATURVERZEICHNIS

Minke, Christine, et al. "Is iridium demand a potential bottleneck in the realization of large-scale PEM water electrolysis?" International Journal of Hydrogen Energy (2021).

Bernsmeier, Denis, et al. "Oxygen evolution catalysts based on Ir-Ti mixed oxides with templated mesopore structure: impact of Ir on activity and conductivity." ChemSusChem 11 (2018): 2367-2374.

Ortel, Erik, et al. "Mesoporous IrO2 films templated by PEO-PB-PEO block-copolymers: selfassembly, crystallization behavior, and electrocatalytic performance." Chemistry of Materials 23 (2011): 3201-3209.

Bernicke, Michael, et al. "Tailored mesoporous Ir/TiOx: Identification of structure-activity relationships for an efficient oxygen evolution reaction." Journal of Catalysis 376 (2019): 209-218.

Daiane Ferreira da Silva, Camila, et al. "Oxygen Evolution Reaction Activity and Stability Benchmarks for Supported and Unsupported IrOx Electrocatalysts." ACS Catalysis 11 (2021): 4107-4116.

Hartig-Weiss, Alexandra, et al. "Iridium oxide catalyst supported on antimony-doped tin oxide for high oxygen evolution reaction activity in acidic media." ACS Applied Nano Materials 3 (2020): 2185-2196.

Geiger, S., et al. "Stability Limits of Tin-Based Electrocatalyst Supports, Sci." (2017): 4595.

## Patentansprüche

1. Verfahren zur Herstellung nanostrukturierter Elektrodenbeschichtungen umfassend folgende Schritte:
a) Bereitstellung eines Trägermaterials, wobei das Trägermaterial ein Edelmetall-Titan-Mischoxid umfasst,
b) Beschichtung des Trägermaterials mit einer katalytisch aktiven Edelmetallspezies mittels Atomlagenabscheidung (ALD),
sodass das Trägermaterial durch die katalytisch aktive Edelmetallspezies oberflächenkonform modifiziert wird.

2. Verfahren nach dem vorherigen Anspruch
**dadurch gekennzeichnet, dass**
das Trägermaterial ein Edelmetall aufweist, wobei das Edelmetall in einem titanbasierten Metalloxid vorliegt, sodass eine elektrische Leitfähigkeit des Trägermaterials variiert werden kann.

3. Verfahren nach einem oder mehreren der vorherigen Ansprüche
**dadurch gekennzeichnet, dass**
das Trägermaterial mit der katalytisch aktiven Edelmetallspezies bei einer Temperatur von T₁ = 120 °C mittels Atomlagenabscheidung oberflächenkonform modifiziert wird, wobei bevorzugt eine Schichtdicke von, durch die Atomlagenabscheidung abgeschiedenen, Atomlagen durch eine Anzahl an Zyklen, Pulsdauern und/oder eingesetzten Präkursoren eingestellt werden kann.

4. Verfahren nach einem oder mehreren der vorherigen Ansprüche
**dadurch gekennzeichnet, dass**
das Trägermaterial bevorzugt eine spezifische Oberfläche zwischen 50 - 500 m²/m²_{geom.Substratfläche} aufweist, bevorzugt zwischen 100 - 200 m²/m²_{geom.Substratfläche}, und/oder das Trägermaterial eine elektrische Leitfähigkeit zwischen 10⁻³ - 10² S/cm aufweist, bevorzugt zwischen 10-³ - 10⁻² S/cm.

5. Verfahren nach einem oder mehreren der vorherigen Ansprüche
**dadurch gekennzeichnet, dass**
ein Edelmetall im Trägermaterial ausgewählt ist aus einer Gruppe umfassend Platinmetalle und/oder einen Anteil zwischen 5 - 75 Gew.-% umfasst, bevorzugt Iridium mit einem relativen Anteil zwischen 25 - 35 Gew.-% im Trägermaterial.

6. Verfahren nach einem oder mehreren der vorherigen Ansprüche
**dadurch gekennzeichnet, dass**
ein Edelmetall mithilfe von Atomlagenabscheidung auf einer gesamten inneren und/oder einer äußeren Oberfläche beschichtet wird, wobei bevorzugt das Edelmetall ausgewählt ist aus der Gruppe der Platinmetalle, besonders bevorzugt Iridium oder Ruthenium.

7. Verfahren nach einem oder mehreren der vorherigen Ansprüche
**dadurch gekennzeichnet, dass**
dass ein auf das Trägermaterial abgeschiedenes Edelmetall in Form einer reduzierten oder oxidierten Spezies vorliegt, bevorzugt in Form eines amorphen und/oder niedrig-kristallinen Metalloxides.

8. Verfahren nach einem oder mehreren der vorherigen Ansprüche
**dadurch gekennzeichnet, dass**
das Trägermaterial und/oder eine abgeschiedene Oberflächenschicht eine oder mehrere Edelmetallspezies aufweist, bevorzugt Kombinationen aus Iridium und/oder Ruthenium und/oder Platin im Trägermaterial sowie Kombinationen aus Iridium und/oder Ruthenium und/oder Platin in der Oberflächenschicht.

9. Verfahren nach einem oder mehreren der vorherigen Ansprüche
**dadurch gekennzeichnet, dass**
eine Temperatur bei der Atomlagenabscheidung in Abhängigkeit der eingesetzten Präkursoren zwischen 25 - 350 °C liegt, bevorzugt zwischen 110 - 130 °C.

10. Verfahren nach einem oder mehreren der vorherigen Ansprüche
**dadurch gekennzeichnet, dass**
eine auf das Trägermaterial abgeschiedene Schicht eine Dicke zwischen 0,1 - 25 nm aufweist, bevorzugt zwischen 1 - 4 nm Dicke orthogonal zur modifizierten Oberfläche.

11. Verfahren nach einem oder mehreren der vorherigen Ansprüche
**dadurch gekennzeichnet, dass**
nach der Beschichtung der katalytisch aktiven Edelmetallspezies mittels Atomlagenabscheidung eine thermische Behandlung erfolgt,
wobei bevorzugt während der thermischen Behandlung eine Temperatur zwischen 325 - 475 °C erfolgt,
wobei bevorzugt die Zeitspanne der thermischen Behandlung zwischen 0 - 300 min beträgt, wobei besonders bevorzugt die thermische Behandlung in einer Luftatmosphäre erfolgt.

12. Verwendung des mittels Atomlagenabscheidung oberflächenmodifizierten Trägermaterials nach Anspruch 1 als Katalysatoren und/oder Katalysatorträger, im Bereich von Photovoltaik, in einer Elektrokatalyse, in einer Photo(elektro)katalyse, in chemischen Hydrierungs-, Alkylierungs- oder Kupplungsreaktionen, in der Medizintechnik, im Maschinenbau, im Bereich einer Optik und/oder einer Optoelektronik, als Energiespeicher und/oder im Bereich einer Schmuckindustrie.
